# EUROPÄISCHE PATENTANMELDUNG

(11) **EP 1 407 828 A2**
(43) Veröffentlichungstag der Anmeldung: **14.04.2004**
(21) Anmeldenummer: 03008221.8
(22) Anmeldetag: 09.04.2003
(51) Int. Cl.: B05B 15/12, B05C 15/00

(54) **Durchlauf-Beschichtungsanlage**

(30) Priorität: 09.10.2002 DE 10247002
(71) Anmelder: Applied Films GmbH & Co. KG, 63755 Alzenau (DE)
(72) Erfinder: Sauer, Andreas, 63762 Grossostheim (DE)
(74) Vertreter: Hebing, Norbert

(57) **Zusammenfassung**

Eine Durchlauf-Beschichtungsanlage hat mehrere separate Behandlungskammern (1, 2), welche derart hintereinander angeordnet sind, dass eine einen Durchlass (5) aufweisende Wand (3) der einen Behandlungskammer (1) gegen eine ebenfalls einen Durchlass (6) aufweisende Wand (4) der angrenzenden Behandlungskammer (2) anliegt. Einer der Durchlässe (5) ist in einem Dichteinsatz (7) vorgesehen, welcher sich jeweils von derselben Seite her mit einer ersten Abstützfläche (9) auf die Wand (3) der einen Behandlungskammer (1) und mit einer zweiten Abstützfläche (10) gegen die Wand (4) der angrenzenden Behandlungskammer (2) abstützt. Zwischen den beiden Abstützflächen (9, 10) und der jeweiligen Wand (3, 4) befindet sich jeweils eine umlaufende, gegen die jeweilige Abstützfläche (9, 10) und die Wand (3, 4) anliegende Dichtung (13, 14).

## Beschreibung

Die Erfindung betrifft eine Durchlauf-Beschichtungsanlage mit mehreren separaten Behandlungskammern, welche derart hintereinander angeordnet sind, dass jeweils eine einen Durchlass aufweisende Wand der einen Behandlungskammer gegen eine ebenfalls einen Durchlass aufweisende Wand der angrenzenden Behandlungskammer anliegt und bei der die beiden Durchlässe durch eine zwischen den Wänden angeordnete Abdichtung nach außen hin abgedichtet sind.

Solche Durchlauf-Beschichtungsanlagen werden beispielsweise als Sputteranlagen gebaut und sind zur Erzeugung von Schichtpaketen auf Substraten allgemein bekannt und gebräuchlich. Sie können derzeit über 30 hintereinander angeordnete Behandlungskammern aufweisen und insgesamt über 100 m lang sein. Die Durchlässe in den stirnseitigen Wänden der Behandlungskammern dienen dazu, die Substrate von einer zur anderen Behandlungskammer transportieren zu können. Um die einzelnen Behandlungskammern gegen den Atmosphärendruck abzudichten, ordnet man derzeit jeweils zwischen den Wänden der einzelnen Behandlungskammern eine den Durchlass umgebende Dichtung an, so dass nach dem Verbinden der einzelnen Wände der Behandlungskammern eine komplette, vakuumdichte Gesamtanlage entsteht.

Nachteilig bei solchen Durchlauf-Beschichtungsanlagen ist es, dass zum Austausch der jeweiligen Dichtung zwischen den Wänden angrenzender Behandlungskammern großer Aufwand erforderlich ist. Wenn beispielsweise im mittleren Bereich einer solchen Anlage eine Dichtung undicht ist, müssen von einer Seite her alle vorgeschalteten Behandlungskammern demontiert werden, um zu der defekten Dichtung gelangen zu können. Das verursacht bei großen Anlagen einen Produktionsausfall von oftmals mehreren Wochen, so dass das Undichtwerden solcher Dichtungen zu wirtschaftlich hohem Schaden führt.

Der Erfindung liegt das Problem zugrunde, eine Durchlauf-Beschichtungsanlage der eingangs genannten Art so zu gestalten, dass der Austausch der zwischen den einzelnen Behandlungskammern angeordneten Dichtungen möglichst einfach und rasch erfolgen kann.

Dieses Problem wird erfindungsgemäß dadurch gelöst, dass einer der Durchlässe in einem Dichteinsatz vorgesehen ist, welcher sich jeweils von derselben Seite her mit einer ersten Abstützfläche auf die Wand der einen Behandlungskammer und mit einer zweiten Abstützfläche gegen die Wand der angrenzenden Behandlungskammer abstützt und dass zwischen den beiden Abstützflächen und der jeweiligen Wand, gegen die sie sich abstützt, jeweils eine umlaufende, gegen die jeweilige Abstützfläche und der Wand anliegende Dichtung vorgesehen ist.

Solche Dichteinsätze lassen sich ohne Trennung der von ihm abgedichteten Behandlungskammern demontieren, weil sie nicht zwischen den Behandlungskammern, sondern innerhalb der Behandlungskammern angeordnet sind und deshalb nach einem Lösen der sie haltenden Befestigungsmittel von der jeweiligen Wand in Richtung des Inneren der Behandlungskammer bewegt werden können. Deshalb kann man die Dichteinsätze aus den einzelnen Behandlungskammern entfernen und dann die jeweiligen Dichtungen auswechseln.

Besonders einfach ist der Dichteinsatz gestaltet, wenn er ringscheibenförmig ausgebildet ist und die eine Abstützfläche durch eine Stirnseite des Dichteinsatzes und die andere Abstützfläche durch eine Abstufung des Dichteinsatzes gebildet ist.

Die Dichtungen lassen sich außerhalb der Behandlungskammer bequem demontieren und montieren, wenn gemäß einer anderen Weiterbildung der Erfindung der Dichteinsatz in jeder seiner beiden Abstützflächen jeweils eine umlaufende Nut mit einem O-Ring als Dichtung hat. Hierdurch brauchen die Dichtungen nicht in die Wände der Behandlungskammern eingesetzt werden, vielmehr kann man die einzelnen, leicht zu handhabenden Dichteinsätze mit den Dichtungen versehen.

Der Dichteinsatz kann bündig in der Wand der ihn aufnehmenden Behandlungskammer angeordnet sein, wenn er mit seiner durch die Abstufung gebildeten Abstützfläche gegen eine Auflagefläche anliegt, die durch eine Ausnehmung in der Wand der den Dichteinsatz aufnehmenden Behandlungskammer gebildet ist.

Die Befestigung der Dichteinsätze ist leicht möglich, indem der Dichteinsatz durch Schrauben gegen die Wände gehalten ist und diese Schrauben von der Wand der an die Behandlungskammer mit dem Dichteinsatz angrenzenden Behandlungskammer aus innerhalb des von der gegen die angrenzende Behandlungskammer anliegenden Dichtung umschlossenen Bereichs der anderen Behandlungskammer in Gewindelöcher des Dichteinsatzes führen. Bei einer solchen Ausführungsform ist sichergestellt, dass über die Schrauben keine Verbindung vom Inneren der Behandlungskammern zur Atmosphäre entsteht, weil die Schrauben innerhalb des von der jeweiligen Dichtung umgrenzten Bereichs von der Wand der einen Behandlungskammer in die Wand der anderen Behandlungskammer gelangen.

Die einzelnen Behandlungskammern werden zur Bildung einer Gesamtanlage mit ihren stirnseitigen Wänden aneinandergeschraubt. Bei kleineren Anlagen kann man auf separate Verbindungsmittel für die einzelnen Behandlungskammern verzichten, wenn der Dichteinsatz mit den von der angrenzenden Behandlungskammer in ihn hineinführenden Schrauben zugleich ein Verbindungselement für die beiden aneinandergrenzenden Behandlungskammern bildet.

Um einzelne Behandlungskammern zueinander abschotten zu können, damit man zu unterschiedlichen Zeitpunkten verschiedene Drücke einstellen kann, ist es üblich, Klappenventile anzuordnen, welche jeweils in der Lage sind, den zur anderen Behandlungskammer führenden Durchlass in der Behandlungskammer zu verschließen. Diese Klappenventile sitzen im geschlossenen Zustand mit einer Dichtung auf einem den Durchlass umgebenden Wandbereich der Behandlungskammer. Durch Fehlfunktionen beim Substrattransport kommt es in der Praxis vor, dass in dem den Ventilsitz bildenden Wandbereich Kratzer entstehen, die die Dichtheit des geschlossenen Klappenventils verhindern. In solchen Fällen war es bisher erforderlich, die Dichtfläche zu schleifen und zu polieren, um solche Kratzer zu beseitigen, was sehr zeitaufwändig war, weil die Dichtflächen innerhalb der Behandlungskammern schwer zugänglich sind. Diesen Aufwand kann man gemäß einer anderen Weiterbildung der Erfindung vermeiden, wenn der Dichteinsatz innerhalb der ihn aufnehmenden Behandlungskammer eine den Durchlass umgebende Dichtfläche für ein Schließglied eines in der Behandlungskammer angeordneten, zum Verschließen des Durchlasses vorgesehenen Klappenventils ist.

Die Gesamtanlage kann aus kostengünstigem Material, beispielsweise Baustahl, hergestellt werden, wenn der Dichteinsatz aus nichtrostendem Edelstahl besteht. Hierdurch muss man nur dort teures Material einsetzen, wo es auf eine dauerhafte, gute Oberflächenbeschaffenheit ankommt.

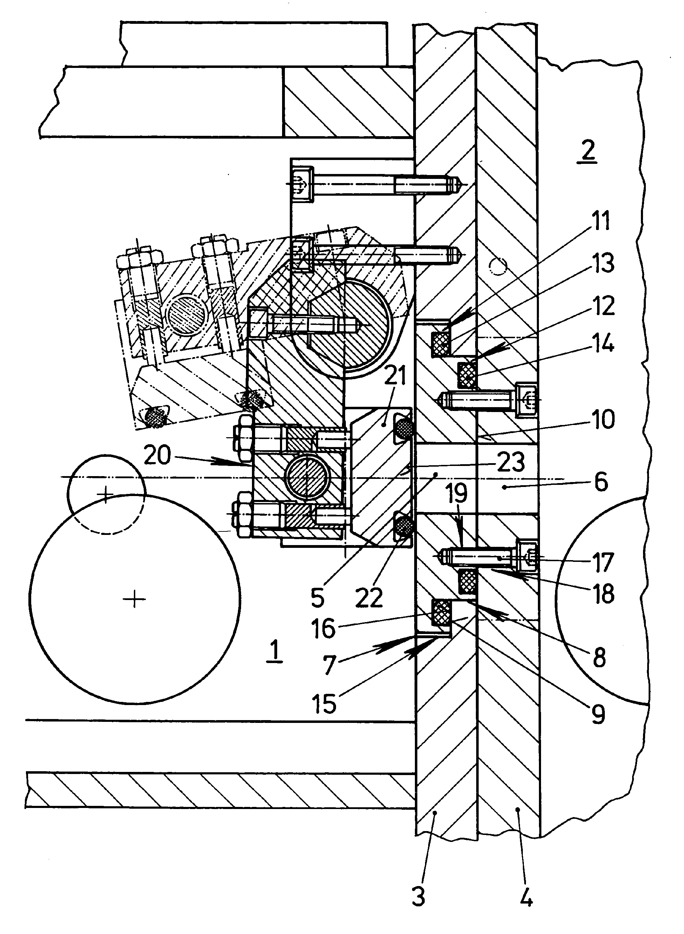

Die Erfindung lässt verschiedene Ausführungsformen zu. Zur weiteren Verdeutlichung ihres Grundprinzips ist in der Zeichnung im Schnitt ein für die Erfindung wesentlicher Teilbereich einer Durchlauf-Beschichtungsanlage dargestellt und wird nachfolgend beschrieben.

Die Zeichnung zeigt von einer Durchlauf-Beschichtungsanlage zwei aneinandergrenzende Bereiche zweier Behandlungskammern 1, 2, welche mit jeweils einer Wand 3, 4 aneinanderstoßen. Ein Durchlass 5 führt von der Behandlungskammer 1 zu einem Durchlass 6 in der Wand 4, so dass die Behandlungskammern 1, 2 durch die Durchlässe 5, 6 miteinander verbunden sind. Diese Durchlässe 5, 6 ermöglichen es, nicht dargestellte Substrate von der einen Behandlungskammer 1 oder 2 in die andere Behandlungskammer 2 oder 1 zu transportieren.

Um zu verhindern, dass zwischen den beiden Wänden 3, 4 eine Verbindung von den beiden Behandlungskammern 1, 2 zur Atmosphäre besteht, ist in der Behandlungskammer 1 ein ringförmiger Dichteinsatz 7 vorgesehen. Aufgrund einer Abstufung 8 hat dieser Dichteinsatz 7 zwei zur gleichen Seite weisende Abstützflächen 9, 10 mit jeweils einer Nut 11, 12, in der sich eine als O-Ring ausgebildete Dichtung 13, 14 befindet. Die Wand 3 hat im Bereich des Dichteinsatzes 7 eine Ausnehmung 15, so dass eine Auflagefläche 16 entsteht. Der Dichteinsatz 7 liegt mit seiner Abstützfläche 9 gegen die Auflagefläche 16 der Wand 3 und gleichzeitig mit seiner Abstützfläche 10 gegen die Wand 4 an. Er wird in dieser Position durch Schrauben 17 gehalten, welche jeweils durch eine Bohrung 18 der Wand 4 hindurchführen und in ein Gewindeloch 19 der Wand 3 geschraubt sind. Dabei befindet sich die Dichtung 14 außerhalb der Gewindelöcher 19 und der Bohrungen 18, so dass keine Atmosphärenverbindung von der Behandlungskammer 2 durch die Bohrungen 18 und zwischen den Wänden 3, 4 hindurch nach außen besteht. Die Dichtung 13 verhindert eine Verbindung von der Behandlungskammer 1 an der Außenseite des Dichtringes 7 vorbei nach außen, während die Dichtung 14, abgesehen von einer Verbindung über die Bohrungen 18, eine Verbindung über die Durchlässe 5, 6 nach außen zur Atmosphäre verhindert.

Die Zeichnung zeigt weiterhin ein Klappenventil 20, welches in der in durchgezogenen Linien dargestellten Position mittels eines Schließgliedes 21 den Durchlass 5 versperrt. Hierzu liegt das Schließglied 21 mit einem Dichtring 22 gegen eine ebene Dichtfläche 23 des Dichteinsatzes 7.

### Bezugszeichenliste

- 1: Behandlungskammer
- 2: Behandlungskammer
- 3: Wand
- 4: Wand
- 5: Durchlass

- 6: Durchlass
- 7: Dichteinsatz
- 8: Abstufung
- 9: Abstützfläche
- 10: Abstützfläche

- 11: Nut
- 12: Nut
- 13: Dichtung
- 14: Dichtung
- 15: Ausnehmung

- 16: Auflagefläche
- 17: Schraube
- 18: Bohrung
- 19: Gewindeloch
- 20: Klappenventil

- 21: Schließglied
- 22: Dichtring
- 23: Dichtfläche

## Patentansprüche

1. Durchlauf-Beschichtungsanlage mit mehreren separaten Behandlungskammern (1, 2), welche derart hintereinander angeordnet sind, dass jeweils eine einen Durchlass (5) aufweisende Wand (3) der einen Behandlungskammer (1) gegen eine ebenfalls einen Durchlass (6) aufweisende Wand (4) der angrenzenden Behandlungskammer (2) anliegt und bei der die beiden Durchlässe (5, 6) durch eine zwischen den Wänden (3, 4) angeordnete Abdichtung nach außen hin abgedichtet sind, **dadurch gekennzeichnet, dass** einer der Durchlässe (5) in einem Dichteinsatz (7) vorgesehen ist, welcher sich jeweils von derselben Seite her mit einer ersten Abstützfläche (9) auf die Wand (3) der einen Behandlungskammer (1) und mit einer zweiten Abstützfläche (10) gegen die Wand (4) der angrenzenden Behandlungskammer (2) abstützt und dass zwischen den beiden Abstützflächen (9, 10) und der jeweiligen Wand (3, 4), gegen die sie sich abstützt, jeweils eine umlaufende, gegen die jeweilige Abstützfläche (9, 10) und die Wand (3, 4) anliegende Dichtung (13, 14) vorgesehen ist.

2. Durchlauf-Beschichtungsanlage nach Anspruch 1, **dadurch gekennzeichnet, dass** der Dichteinsatz (7) ringscheibenförmig ausgebildet ist und die eine Abstützfläche (10) durch eine Stirnseite des Dichteinsatzes (7) und die andere Abstützfläche (9) durch eine Abstufung (8) des Dichteinsatzes (7) gebildet ist.

3. Durchlauf-Beschichtungsanlage nach den Ansprüchen 1 oder 2, **dadurch gekennzeichnet, dass** der Dichteinsatz (7) in jeder seiner beiden Abstützflächen (9, 10) jeweils eine umlaufende Nut (11, 12) mit einem O-Ring als Dichtung (13, 14) hat.

4. Durchlauf-Beschichtungsanlage nach zumindest einem der vorangehenden Ansprüche, **dadurch gekennzeichnet, dass** der Dichteinsatz (7) mit seiner durch die Abstufung (8) gebildete Abstützfläche (9) gegen eine Auflagefläche (16) anliegt, die durch eine Ausnehmung (15) in der Wand (3) der den Dichteinsatz (7) aufnehmenden Behandlungskammer gebildet ist.

5. Durchlauf-Beschichtungsanlage nach zumindest einem der vorangehenden Ansprüche, **dadurch gekennzeichnet, dass** der Dichteinsatz (7) durch Schrauben (17) gegen die Wände (3, 4) gehalten ist und diese Schrauben (17) von der Wand (4) der an die Behandlungskammer (1) mit dem Dichteinsatz (7) angrenzenden Behandlungskammer (2) aus innerhalb des von der gegen die angrenzende Behandlungskammer anliegenden Dichtung (14) umschlossenen Bereichs der anderen Behandlungskammer (1) in Gewindelöcher (19) des Dichteinsatzes (7) führen.

6. Durchlauf-Beschichtungsanlage nach zumindest einem der vorangehenden Ansprüche, **dadurch gekennzeichnet, dass** der Dichteinsatz (7) mit den von der angrenzenden Behandlungskammer (2) in ihn hineinführenden Schrauben (17) zugleich ein Verbindungselement für die beiden aneinandergrenzenden Behandlungskammern (1, 2) bildet.

7. Durchlauf-Beschichtungsanlage nach zumindest einem der vorangehenden Ansprüche, **dadurch gekennzeichnet, dass** der Dichteinsatz (7) innerhalb der ihn aufnehmenden Behandlungskammer (1) eine den Durchlass (5) umgebende Dichtfläche (23) für ein Schließglied (21) eines in der Behandlungskammer (1) angeordneten, zum Verschließen des Durchlasses (5) vorgesehenen Klappenventils (20) ist.

8. Durchlauf-Beschichtungsanlage nach Anspruch 7, **dadurch gekennzeichnet, dass** der Dichteinsatz (7) aus nichtrostendem Edelstahl besteht.
